# EUROPEAN PATENT APPLICATION

(11) **EP 2 174 989 A1**
(43) Date of publication of application: **14.04.2010**
(21) Application number: 08166116.7
(22) Date of filing: 08.10.2008
(51) Int. Cl.: C09C 1/00, C09C 1/04, C09C 1/24, C09C 1/30, C09C 1/36, C09C 1/40, C09C 3/12

(54) **Aqueous metaloxide dispersions and coating materials prepared thereof.**

(71) Applicant: ChemIP B.V., 6167 RD Geleen (NL)
(72) Inventor: Currie, Edwin, 6133 AM Sittard (NL); Van de Belt, Roelof, 5684 GH Best (NL)
(74) Representative: DeltaPatents B.V.

(57) **Abstract**

A composition comprising 20-60 wt% of metaloxide grafted with a silane component Z, 40-80 wt% water, less than 1 wt% of an organic solvent, less than 0,1 wt% of a surfactant, wherein Z is a component according to the formula

Y-O-Cₙ-Si-(OR)₃

wherein Y is H, an hydroxy functional C₁-C₂₀ hydrocarbylgroup, or an epoxy functional C₁-C₂₀ hydrocarbyl group, Cₙ is a hydrocarbyl bridging group comprising between 1 and 10 C atoms and each R independently is hydrogen or a C₁-C₁₀ hydrocarbyl group. The invention also relates to a latex composition comprising said grafted metaloxide particles and to a film prepared from the latex composition.

## Description

The invention relates to aqueous metaloxide dispersions, to latex compositions containing metaloxide particles and the use of such latex compositions in for example coating applications.

Thin functional composite coatings are of interest in e.g. the glass industry, electronics, specialty packaging, solar cells and architectural film applications. Besides mechanical aspects the optical characteristics of the functional films are of prime importance. For automotive, solar cell and architectural film applications in particular, the transmission in the visible range as well as absorption/reflection of UV and (near) infra-red radiation is of utmost importance.

In the literature a number of methods are given to prepare nano-dispersions which result in optical films consisting of nanoparticles in a polymeric binder. Dispersions of nanoparticles in organic solvents are known in the art. These dispersions are prepared by adding different kinds of dispersants to the nanoparticles. EP1008564 A2 / WO2006-016729 (Sumitomo Osaka Cement) discloses preparation of nanodispersions containing ITO and ATO powders ethers using 1-10wt% dispersion agent. JP9108621 (Nippon Kayaku) shows the use of carboxylic acids as dispersion agents for ATO and ITO nanopowders. WO2004-039891 (JSR) teaches the use polyvinylbutyral to disperse SiO2 coated TiO2 in an organic solvent. JP08067837 A (Mitsubishi Materials Corporation) teaches the application of dialkyl phosphite titanate as a dispersing agent for ATO.
In a further step it may be possible to graft the nanoparticles in the presence of the dispersant agents with compounds having reactive groups. For instance, in WO2006-054888 A2 (JSR/DSM) zirconium oxide, antimony oxide and zinc doped antimony oxide is grafted with a silane coupling agent to provide a dispersion in organic solvents and reactivity in a UV curable resin. All dispersions from nanoparticles in organic solvents known in the art have considerable amounts of dispersants present. These dispersants show a number of disadvantages. The dispersants are surface active compounds and can impart undesirable properties to the coating formulation. For instance, the dispersion agents can bloom to the surface and affect adhesion of the coating to the substrate or optical quality of the coated product. Moreover, these dispersions contain a high amount of organic solvents. Due to the increasing restraint on the use of volatile organic compounds (VOC's) in coating formulations, the aforementioned methods are not desirable.
An additional functionality, that is needed in certain applications, is the electric conductivity of optical films. As polymer matrices are typically insulators, additives are used to increase the conductivity of the polymer matrix. One way to improve conductivity or antistatic properties of an optical film is introducing (semi)conducting particles like tin doped indiumoxide (ITO) or antimony doped tinoxide (ATO). For instance, Eastman Kodak Company describes the preparation of films comprising latex and gelatin binder in combination with conductive nanoparticles (see Macromolecules 1999, 32, 6172-9).This latex comprises a low amount of ATO without surface modification, just above the percolation threshold. Although the films have conductivity, the optical properties are poor.

It is therefore desirable to combine functional metaloxide nanoparticles with environmental friendly aqueous binder materials, for instance polymeric latexes. However, this leads to a number of problems. For instance, waterborne latex coatings are electrically charged, as are metaloxide particles. However, as the charges are not similar, the mixing often leads to destabilization of the dispersions.
Moreover, an aqueous dispersion of metaloxide particles shows a decreased stability when the weight fraction of the metaloxide particles is increased, resulting in for example a poor shelf life of the dispersion or the coating products thereof. Typically, surfactants and dispersants are used to improve the dispersion stability of metal oxide particles in water. On the other hand, surfactants and dispersants can destabilize the polymeric latex or bloom to the surface of the dried film, resulting in suboptimal optical appearance and or loss of adhesion.
Furthermore, when an aqueous latex dispersion and an aqueous nanoparticle dispersion are mixed and applied as a coating, the latex particles consolidate and force the nanoparticles to segregate into the boundary regions between the latex particles. This results in nanoparticle aggregates which scatter light, leading to a high haze and loss of optical transmission.

It is therefore an object of the present invention to provide an aqueous coating composition comprising a polymeric latex and metaloxide nanoparticles which is stable at a high wt% of nanoparticles. It is a further object to provide an aqueous coating composition comprising a polymeric latex and nanoparticles which upon coating and drying gives a functional film with for example high optical clarity.

The present invention relates to a composition comprising
20-60 wt% of metaloxide grafted with a silane component Z
40-80 wt% water,
less than 1 wt% of an organic solvent
less than 0,1 wt% of a surfactant
wherein Z is a component according to the formula

Y-O-Cₙ-Si-(OR)₃

wherein Y is H, an hydroxy functional C₁-C₂₀ hydrocarbylgroup,or an epoxy functional C₁-C₂₀ hydrocarbyl group, Cₙ is a hydrocarbyl bridging group comprising between 1 and 10 C atoms and each R independently is hydrogen or a C₁-C₁₀ hydrocarbyl group.
A C₁-C₁₀ hydrocarbylgroup is a hydrocarbylgroup having between 1 and 10 C-atoms, and a C₁-C₂₀ hydrocarbyl group is a hydrocarbyl group having between 1 and 20 C-atoms. The hydrocarbylgroup may contain hetero atoms like (or example O, N, Si or halogen atoms).

The invention also relates to a latex composition comprising the grafted metaloxide nanoparticles. The inventors have discovered that a novel surface modification of the metal oxide particles yields stable aqueous metaloxide dispersions at high wt% of nanoparticles with no dispersing agents or surfactants. Moreover, novel coating materials with excellent stability can be prepared with the metaloxide dispersions and aqueous latex dispersions.

Finally, the novel coating materials give excellent optical and mechanical properties upon application on a substrate and drying. The invention also relates to a process to prepare the latex composition.

### Detailed description of the invention.

Within the scope of the invention the disclosure relates to metaloxide particles in general and metal oxide particles with a mean diameter below 100nm in particular. Examples of metaloxide particles are nanoparticle metal oxides that may be selected from for example Al₂O₃, Fe₂O₃, Fe₃O₄, In₂O₃, SnO₂, SiO₂, ZnO, oxides of Ti, Zr, Hf, Nb, Ta, Cr, Mo, W or mixed metal oxide like Al/Sn:ZnO, Sb/Zn:SnO₂, Sn:In₂O₃, and the like.
Preferably the metal oxide particles are antimony doped tinoxide (ATO) particles.

In order to provide aqueous dispersions of grafted metaloxide particles with a high stability at high wt% without dispersing agents or surfactants the nanoparticles are reacted with silane components Z comprising at least one alkoxy group and at least a group selected from hydroxy, epoxy.
Examples of silane component Z are 3-glycidoxypropyltri(m)ethoxysilane, 3-glycidoxypropylmethyldi(m)ethoxysilane, 3-glycidoxypropyldimethylethoxysilane, 5,6-epoxyhexyltriethoxysilane, 2-(3,4-epoxycyclohexyl)tri(m)ethoxysilane, hydroxymethyltri(m)ethoxysilane, hydroxyethyltri(m)ethoxysilane, hydroxymethylmethyldi(m)ethoxysilane and the like.

These silane components Z may also be used in a mixture with other silanes like for example methacryloxypropyltri(m)ethoxysilane, methacryloxymethyltrimethoxysilane, methacryloxypropyltris(methoxy-ethoxy)silane, but the amount of silane components Z is preferably higher than the amount of other silanes.

In the present invention, the dispersions of grafted metaloxide particles do not contain substantial amounts of an organic solvent and also have only very limited amount of dispersants. The silane component Z or its reaction products is not considered to be a dispersant in the definition of the present invention. The dispersion of grafted metaloxide particles may contain unreacted silane component Z, or reaction products of silane component Z that are not bound to the surface of the metal oxide particles.

The presence of dispersants or other surface-active agents can be measured by for instance a bubble test following ASTM 1331-89 (test method for surface and interfacial tension of solutions containing surface-active agents) or by measuring the surface tension of the solution with a rig method following ASTM 971-99a (test method for interfacial tension of oil against water by the rig method) or qualitatively be classified by IR absorption according to ASTM D2357.

The dispersion of grafted metaloxide particles is prepared by reacting the metaloxide particles with silane component Z. The metaloxide nanoparticles can be reacted with the silane component Z according to methods known in the art. The wt% of metal oxide particles in the dispersion of ungrafted metal oxide (prior to reaction with the silane component Z) is between 1 - 30 wt%, in a preferred embodiment between 10 - 25 wt%. The wt% of silanes with respect to the solid weight of metaloxide particles is 2 -50wt%, in a preferred embodiment 5 - 30wt%, more preferably 10-20 wt%.
The reaction of metaloxide and silane component Z may be performed at ambient temperature or at elevated temperature. The pressure during (part) of the reaction is atmospheric, elevated or reduced. The reaction can be accelerated by the known methods, such as addition of acid, base, solid catalysts etc. In general the metal oxide particles are modified with silane component Z when the metal oxide is present in an amount between 1-30wt%, preferably between 10 - 25wt% in water. In order to increase the solid content of the modified nano dispersions, part of the water may be evacuated with methods known to the art (for instance by use of rotation vacuum distillation) to at least 30wt%, or even above 40wt%.
After addition of the silane component Z, the mixture is typically reacted at a temperature between 50 and 100° C, preferably between 60 and 90° C. The reaction time is typically between 1 and 48 hours, preferably between 5 and 16 hours. In a preferred embodiment of the invention, the dispersion of grafted metaloxide nanoparticles is prepared by
a) Providing a dispersion of metaloxide nanoparticles in water or a water/organic solvent mixture, having substantially no surfactants
b) Adding silane component Z
c) Heating the mixture for a period between 4 and 24 hours at a temperature between 60 and 90° C
d) Removing the organic solvent and excess water by distillation and concentrating the obtained dispersion of grafted metaloxide particles to a desired wt%.

The water in step a) may contain an organic solvent like for example ethanol, methanol or aceton , which can be easily removed from the dispersion after the grafting reaction. An organic solvent may also be added in step b) for dissolving the silane component Z
In a preferred embodiment the dispersion of grafted metaloxide particles is distilled or densified to a dispersion containing at least 25 wt%, preferably at least 35 wt%, most preferably at least 40 wt% grafted metaloxide relative to the total of weight of the dispersion of grafted metaloxide particles.

The invention also relates to a latex composition, comprising a metal oxide, for example ATO, grafted with silane component Z and polymeric binder materials.
The latex composition comprises generally between 10 and 40- wt% of metal oxide particles, preferably between 15 and 35 wt%, more preferably between 20 and 30 wt%. The latex composition generally contains between 10 and 40 wt% of polymeric binder, preferably between 15 and 35 wt%.
The total amount of solids of the latex composition may vary between 20 and 70 wt%, preferably between 30 and 65 wt%, in one preferred embodiment between 40 and 60 wt%, most preferably between 45 and 60 wt%.
The amount of metal oxide particles can be determined by for example determination of the weight % of metal by methods like XRF, ICP-AES or ICP-MS and the like. The amount of grafting is not taken into consideration when the amount of ATO is determined in the latex composition, for reasons of simplicity and ease of determination of the amount of nanoparticles filler.

The total amount of solids may be determined by simply drying the latex composition and measuring the weight of the latex before and after the drying process.

There is no limitation for the binder material provided it can be used in an aqueous solution or emulsion. In a preferred embodiment the binder may include homopolymers or copolymers including vinyl acetate/ethylene copolymers, vinyl acetate/acrylic copolymers, homopolymers of vinyl acetate, homopolymers of acrylics, styrene/butadiene copolymers or any combination thereof. Mixtures of polymers dispersions formed by different processes or containing significantly different polymers may be used. The emulsion resin may also include functional monomers such as carboxylic acid functional monomers, hydroxyl functional monomers, monomers containing aziridine groups and the like, which can participate in chemical reactions during or after the drying step. The latex polymer is stabilized in an aqueous medium with emulsifiers, surfactants, and/or protective colloids as is known in the art. The surfactants used in connection with the processing aid may be either anionic, non-ionic, or cationic surfactants. There are no limitations to the use of thickeners, additives, pigments or crosslinkers in the emulsion. Additives include, for example, neutralizing agents, leveling agents and surfactants, rheology modifiers, co-solvents, corrosion inhibitors, and biocides. Examples of binder materials are NeoRez R-986, UVIatex, Halwedrol UV-14, NeoRad R-440, NeoRad R-448 (from DSM Neoresins); Primal B85, Primal Eco-15R (from Rohm and Haas); LET-406, LET-385A (from Rhodia) and Craymul 2171 from Cray Valley).

There are no specific limitations to the substrates to which the coatings comprising the nanodispersions are applied. The substrates include metals, ceramics, glass, plastics, wood, slates, or the like without specific limitations. It is preferable to apply the latex composition to a film-type or sheet-type substrate. A plastic film or a plastic sheet is a particularly preferable material. As examples of plastic, polycarbonate, polymethylmethacrylate, polystyrene/polymethylmethacrylate copolymer, polystyrene, polyester, polyolefin, triacetylcellulose resin, diallylcarbonate of diethylene glycol (CR-39), ABS resin, AS resin, polyamide, epoxy resin, melamine resin, cyclic polyolefin resin (norbornene resin, for example), and the like can be given. The coating comprising the nanodispersions can be applied directly to the substrate or after a processing step. Such steps may be, for example, a cleaning step, corona treatment, or a sputtering step.
The nanodispersions can be applied in coatings to give substrates desired functionalities. In one embodiment the coatings can provide antistatic, EMI shielding or conductive properties to the coated substrates. These may be applied in safety applications, clean rooms, electronic films, RFID films or specialty packaging. In another embodiment the coatings provide absorption in the UV or NIR regime together with a high transparency in the visible regime. These may be applied in climate control films, architectural or automotive window films or UV absorptive films for decreased yellowing and degradation.
There are no specific limitations to the method of applying the composition. For example, a conventional method such as gravure, Mayer rod, a roll coating method, spray coating method, flow coating method, dipping method, screen printing method, or ink jet printing method may be used.
Following the latex coating step, additional coating or processing steps can be taken. These include, but are not limited by, overcoating with a protective coating, lamination, overcoating with an adhesive layer a.s.o.

### Examples

### Sample preparation:

### Comparative Experiment A:

An aqueous dispersion of ATO (ATO3-23%-AQ from Kriya Materials B.V., the Netherlands) is densified at elevated temperature at reduced pressure in a Büchi rotavapor to 35.3wt% solids. At this solid content the pot-life of the dispersion is short due to gellation (gels within a day at room temperature).

### Comparative Experiment B:

2,66 gr 3-methacryloxypropyl trimethoxy silane (Dynasylan MEMO from Degussa, Germany) is dissolved in 58.90 gram methanol (Merck). 61.14 grams of the obtained solution is slowly added to 150,0 gr 12wt% aqueous ATO dispersion (ATO-12%-AQ from Kriya Materials B.V., the Netherlands). The obtained mixture was heated for 4 hr at 75° C and subsequently filtered over 1 µm. The methanol and part of the water is distilled off under reduced pressure in a Büchi rotavapor until solid content in the remaining stable dispersion is 23,4wt% solids. The amount of organic solvents in the remaining stable dispersion < 0.5wt%. The stability of the grafted dispersion in itself was limited (at relative low solid content of 20-25w% it gels within a few days), and mixing the dispersion with a latex immediately leads to gelation (see table 3).

### Example 1:

A series of three samples is prepared with increasing amounts of 3-glycidoxypropyltrimethoxy silane (Dynasilan GLYMO from Degussa, Germany) by adding different amounts of GLYMO directly to an aqueous ATO dispersion (ATO3-23%-AQ from Kriya Materials B.V., the Netherlands). The exact amounts are given in table 1. Subsequently the mixtures 1A-1C are heated for 16 hr at 76 °C.
After heating the obtained mixtures for 16 hr at 73-78 °C the respective dispersions are densified under reduced pressure in a rotavapor until the solid content is appr. 43wt%.

**Table 1: GLYMO series**

| Sample | ATO-23% -AQ Gram | GLYMO Gram | %GLYMO/ ATO (solids) | Heating | Solids Wt% |
|---|---|---|---|---|---|
| CE A | 234.2 | 0 | 0 | - | 35.3 |
| Ex 1A | 256.0 | 2.59 | 4.36 wt% | 16hr/76C | 41.3 |
| Ex 1B | 250.6 | 4.37 | 7.52wt% | 16hr/76C | 42.3 |
| Ex 1C | 252.6 | 7.56 | 12.9wt% | 16hr/73C | 45.5 |

### Example 2:

1.39 gr 3-glycidoxypropyltrimethoxy silane (Dynasilan GLYMO from Degussa, Germany) is dissolved in 105.1 gram methanol and slowly added to 116,6 gr 11wt% aqueous ATO dispersion (ATO3-11%-AQ from Kriya Materials B.V., the Netherlands). After heating the obtained mixture for 4.5 hr at 75 °C the methanol and part of the water is distilled off by heating under reduced pressure in a rotavapor. After the obtained dispersion is filtered over 1µm, the solid content of the product is determined on 36.8wt%. The amount of organic solvents in the remaining stable dispersion is < 0.5wt%

### Example 3:

Six samples of each 40.0 gr of a 23.3wt% aqueous ATO dispersion (ATO-23.3%-AQ from Kriya Materials B.V., the Netherlands) are prepared (sample A-F). To these samples different amounts of GLYMO and MEMO are added. The exact amounts are given in table 2. Subsequently the mixtures A-F are heated for 53 hr at 50 °C.

**Table 2: amounts of GLYMO and MEMO**

| Sample | ATO gram(23 w%aq) | GLYMO gram | % GLYMO/ATO (solids) | MEMO Gram | % MEMO/AT O (solids) | Total Solids wt% |
|---|---|---|---|---|---|---|
| Ex 3A | 40.0 | 0.49 | 5.26 | 0.23 | 2.47 | 24.2 |
| Ex 3B | 40.0 | 1.00 | 10.73 | 0.23 | 2.47 | 24.8 |
| Ex 3C | 40.0 | 1.80 | 19.32 | 0.23 | 2.47 | 25.7 |
| Ex 3D | 40.0 | 0.49 | 5.26 | 0 | 0 | 23.9 |
| Ex 3E | 40.0 | 1.00 | 10.73 | 0 | 0 | 24.5 |
| Ex 3F | 40.0 | 1.80 | 19.32 | 0 | 0 | 25.4 |

### Example 4:

Some of the above mentioned dispersions are mixed with commercial latexes like a mixture of the PRIMAL latexes B85 and Eco 15R (from Rohm & Haas) in the ratio 1 to 2 and Craymul CM2171 (from Cray Valley).
The potlife of the mixtures is evaluated by visual inspection of the rheology the formulation.

**Table 3; potlife of different compositions**

| Example | ATO dispersion | | | | Latex (44.5w% solids) | | ATO/late x | Geltime |
|---|---|---|---|---|---|---|---|---|
| | w% GLYM O | w% MEM O | w% solids | mass | CM217 1 | B15/B85^{#)} | solids-ratio | |
| CE 3a | none | none | 34.8 | 4.56 | 5.18^{&)} | | 0.69 | < 1 day |
| CE 3b | none | none | 34.8 | 4.43 | | 5.00 | 0.69 | < 1 day |
| CE 3c | none | 10 | 23.4 | 5.00 | | | 0.66 | < 1 day |
| Ex 3d | 10 | none | 34.7 | 4.29 | 5.04 | | 0.66 | 2wk |
| Ex 3e | 10 | none | 34.8 | 4.27 | | 5.02 | 0.67 | 2-3wk |
| Ex 3f | 15 | none | 34.8 | 4.37 | 5.12 | | 0.67 | > 1month |
| Ex 3g | 15 | none | 34.6 | 4.30 | | 5.01 | | > 1month |
| Ex 3h | 25.2 | none | 34.8 | 4.28 | 5.03 | | 0.67 | > 1 month |
| Ex 3i | 25.2 | none | 34.8 | 4.27 | | 5.00 | 0.67 | > 1month |
| Ex 3j | 5 | 7.5 | 34.8 | 4.31 | 5.09 | | 0.66 | not determined |
| Ex 3k | 10 | 5.2 | 34.8 | 4.31 | 5.08 | | 0.66 | not determined |
| Ex 3I | 10.3 | 10.3 | 34.6 | 4.29 | 5.07 | | 0.66 | not determined |

| | | | | | | | | |
|---|---|---|---|---|---|---|---|---|
| #) B15/B85 = pre-mix of 1 part B15 to 2 parts B85 &) gelled upon mixing with CM2171 | | | | | | | | |

### Example 5 (coating preparation/application):

Before applying the CM2171 based formulations 0.81-0.83 gr Basonat HW 180 PC (an isocyanate of BASF, Germany) is added. After mixing, the obtained formulations (see table 4) are applied on PET films (Mitsubishi PET as well as 126 micron Melin Example from Du Pont) with a Mayer (rod #12). After the film is applied, the film is dried for 5 minutes at 150° C. The films are left at room temperature for at least 30 minutes before testing.

### Example 6: Characterisation of coated substrates

The coated substrates were characterized using the following techniques. The coated substrate was inspected visually for defects and appearance. The total visual transmission and haze of the coated substrate was measured using a Byk-Gardner Haze-guard plus. The pencil hardness was measured according to ASTM D3363. The ranking starts at low hardness (4B, 3B, 2B, 1B, HB, F) towards higher hardness (H, 2H, 3H etc). Adhesion is tested according to ASTM 3359-97

**Table 4; optical and mechanical performance after application on PET film (applied by Mayer rod #12 and dried 5' at 150C)**

| Example | composition | Basonat *) | Transmission #) | Δ Haze ##) | Adhesion |
|---|---|---|---|---|---|
| CE 4a | CE 3a | too gelly | too gelly to apply | too gelly to apply | |
| CE 4b | CE 3b | | too gelly to apply | too gelly to apply | |
| CE 4c | CE 3c | 0.71 | too gelly to apply | too gelly to apply | |
| Ex 4d | Ex 3d | 0.81 | 87.3 | 1.1 | 100% |
| Ex 4e | Ex 3e | | 87.2 | 6.4 | 100% |
| Ex 4f | Ex 3f | 0.82 | 89.6 | 1.1 | 100% |
| Ex 4g | Ex 3g | | 87.5 | 8.8 | 100% |
| Ex 4h | Ex 3h | 0.82 | 90.3 | 0.8 | 100% |
| Ex 4i | Ex 3i | | 86.0 | 9.9 | 100% |
| Ex 4j | Ex 3j | 0.81 | 86.1 | 7.3 | 100% |
| Ex 4k | Ex 3k | 0.83 | 88.4 | 4.9 | 100% |
| Ex 4I | Ex 3I | 0.83 | 87.5 | 11.1 | 100% |

| | | | | | |
|---|---|---|---|---|---|
| *) Harder = Basonat HW 180 PC and is mixed with the Craymul 2171 compositions #) Transmission is relative w.r.t. uncoated PET foil (Mitsubishi PET) ##) Δ haze is increase in haze w.r.t. uncoated PET foil (Mitsubishi PET) | | | | | |

### Example 7 (IR absorption):

Three coated substrates were prepared with coatings Ex 4c by using three different Mayer rods (no. 12, 18 and 24 respectively) leading to three different layer thicknesses.

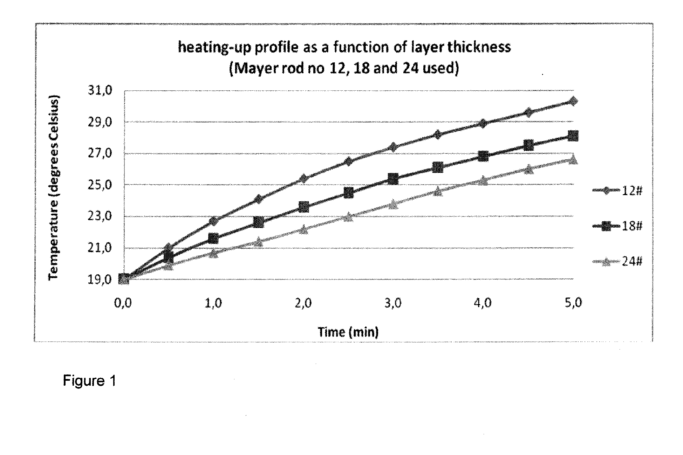

The heat absorption of the respective foils is measured by exposing a 56x140 mm coated foil with 300 Watt IR-lamp at a distance of 220 mm. The temperature gradient behind the foil is measured with thermo couples. Results of the temperature increase as a function of time are shown in figure 1 showing a heating up profile of film as a function of time.

## Claims

1. A composition comprising
a) 20-60 wt% of metaloxide grafted with a silane component Z
b) 40-80 wt% water,
c) less than 1 wt% of an organic solvent
d) less than 0,1 wt% of a surfactant
wherein Z is a component according to the formula
Y-O-Cₙ-Si-(OR)₃
wherein Y is H, an hydroxy functional C₁-C₂₀ hydrocarbylgroup, or an epoxy functional C₁-C₂₀ hydrocarbyl group,
Cₙ is a hydrocarbyl bridging group comprising between 1 and 10 C atoms and each R independently is hydrogen or a C₁-C₁₀ hydrocarbyl group.

2. The composition according to claim 1, wherein the metaloxide particles are antimony doped tinoxide (ATO) particles.

3. The composition according to claim 1 or 2, wherein silane component Z is chosen from the group consisting of 3-glycidoxypropyltri(m)ethoxysilane, 3-glycidoxypropylmethyldi(m)ethoxysilane, 3-glycidoxypropyldimethylethoxysilane, 5,6-epoxyhexyltriethoxysilane, 2-(3,4-epoxycyclohexyl)tri(m)ethoxysilane, hydroxymethyltri(m)ethoxysilane, hydroxyethyltri(m)ethoxysilane, hydroxymethylmethyldi(m)ethoxysilane.

4. A method of preparing a dispersion of metaloxide nanoparticles comprising the steps of.
a) Providing a dispersion of metaloxide nanoparticles in water or a water/organic solvent mixture, having substantially no surfactants
b) Adding silane component Z
c) Heating the mixture for a period between 4 and 24 hours at a temperature between 60 and 90 °C
d) Removing the organic solvent by distillation and concentrating the obtained dispersion of grafted metaloxide particles to a desired weight %,wherein silane component Z is a component according to the formula
Y-O-Cₙ-Si-(OR)₃
wherein Y is H, an hydroxy functional C₁-C₂₀ hydrocarbylgroup,or an epoxy functional C₁-C₂₀ hydrocarbyl group, Cₙ is a hydrocarbyl bridging group comprising between 1 and 10 C atoms and each R independently is hydrogen or a C₁-C₁₀ hydrocarbyl group.

5. The method of claim 4, wherein an organic solvent may be present in step a or b.

6. The method of claim 5, wherein the organic solvent is ethanol, methanol or aceton.

7. The method according to anyone of claims 4-6, wherein the amount of metaloxide particles used in step a is between 10-25 wt%.

8. The method according to anyone of claims 4-7, wherein the wt% of component Z with respect to the solid weight of metaloxide particles in step a is between 5-30%.

9. The method according to anyone of claims 4-8, wherein the amount of solids after step d is at least 25 wt%.

10. The method according to anyone of claims 4-8, wherein the amount of solids after step d is at least 35 wt%.

11. A latex composition, comprising ATO, grafted with component Z and polymeric binder materials, wherein component Z is a component according to the formula
Y-O-Cₙ-Si-(OR)₃
wherein Y is H, an hydroxy functional C₁-C₂₀ hydrocarbylgroup, or an epoxy functional C₁-C₂₀ hydrocarbyl group, Cₙ is a hydrocarbyl bridging group comprising between 1 and 10 C atoms and each R independently is hydrogen or a C₁-C₁₀ hydrocarbyl group.

12. The latex composition according to claim 10 or 11, wherein the latex composition comprises between 10 and 40- wt% of ATO particles, preferably between 15 and 35 wt%, more preferably between 20 and 30 wt%.

13. The latex composition according to anyone of claims 10-12, wherein the total amount of solids of the latex composition varies between 20 and 70 wt%, preferably between 30 and 65 wt%.

14. The latex composition according to anyone of claims 10-12, wherein the latex composition comprises between 40 and 60 wt%, most preferably between 45 and 60 wt%.
